(19)

Europäisches
Patentamt
European
Patent Office
Office européen
des brevets

(11)     **EP 1 933 450 A1**

(12)

# EUROPEAN PATENT APPLICATION
published in accordance with Art. 153(4) EPC

(43) Date of publication:
**18.06.2008 Bulletin 2008/25**

(51) Int Cl.:
**H02M 7/48** (2007.01)     **H02M 1/08** (2006.01)

(21) Application number: **06797544.1**

(22) Date of filing: **06.09.2006**

(86) International application number:
**PCT/JP2006/317649**

(87) International publication number:
**WO 2007/032238 (22.03.2007 Gazette 2007/12)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **13.09.2005 JP 2005265013**

(71) Applicant: **Toshiba Carrier Corporation
Tokyo 105-8001 (JP)**

(72) Inventors:
• **MOCHIKAWA, Hiroshi
  Minato-ku, Tokyo (JP)**
• **NUKUSHINA, Harunobu
  Minato-ku, Tokyo (JP)**

(74) Representative: **HOFFMANN EITLE
Patent- und Rechtsanwälte
Arabellastrasse 4
81925 München (DE)**

(54)     **POWER CONVERTER**

(57)     A pair of main circuit switching elements wherein at least one of the pair of main circuit switching elements is a FET having a diode connected in anti-parallel to the FET, a unit to generate a PWM signal, a delay unit to delay an ON signal of the PWM signal for a predetermined time, a switching signal correction unit to compare a delay time and an ON time of a PWM signal and keep ON state of other switching element when the ON time of the PWM signal is shorter than the delay time, and a reverse voltage application unit to apply reverse voltage on the diode.

## FIG. 2

**Description**

**TECHNICAL FIELD**

The present invention relates to a power conversion device for supplying power to an inductive load with use of at least one FET for main circuit switching elements.

**BACKGROUND ART**

There has been conventionally suggested a power conversion device using FETs for a pair of switching elements provided in an inverter circuit thereof for driving an inductive load (for example, Japanese patent, application laid-open H10-327585). This power conversion has a reverse voltage application circuit to reduce a loss by reverse current on a parasitic diode connected in anti-parallel to a MOSFET as a switching element, along with a switching of the MOSFET. Here a parasitic diode is a natural by-product of a MOSFET. With this reverse voltage application circuit it is enabled to apply reverse voltage on the parasitic diode, after the MOSFET is changed from ON to OFF and before another MOSFET is changed from OFF to ON. The reverse voltage is applied based on a drive signal that is generated from a combination of a PWM (Pulse Wide Modulation) signal and an OFF signal for a MOSFET for which reverse voltage is to be applied. The PWM signal is generated by a comparison between a triangle signal and a reference signal based on a reference frequency and a reference voltage.

**DISCLOSURE OF THE INVENTION**

The Japanese patent application laid-open H10-327585 uses a signal that is processed from a PWM signal and a switching signal with a delay to prevent concurrent ON signals on switching elements to generate a drive signal to apply reverse voltage.

The generation of a drive signal for applying reverse voltage sometimes fails due to a relationship between a pulse width of a PWM signal and a delay time of a delay circuit.

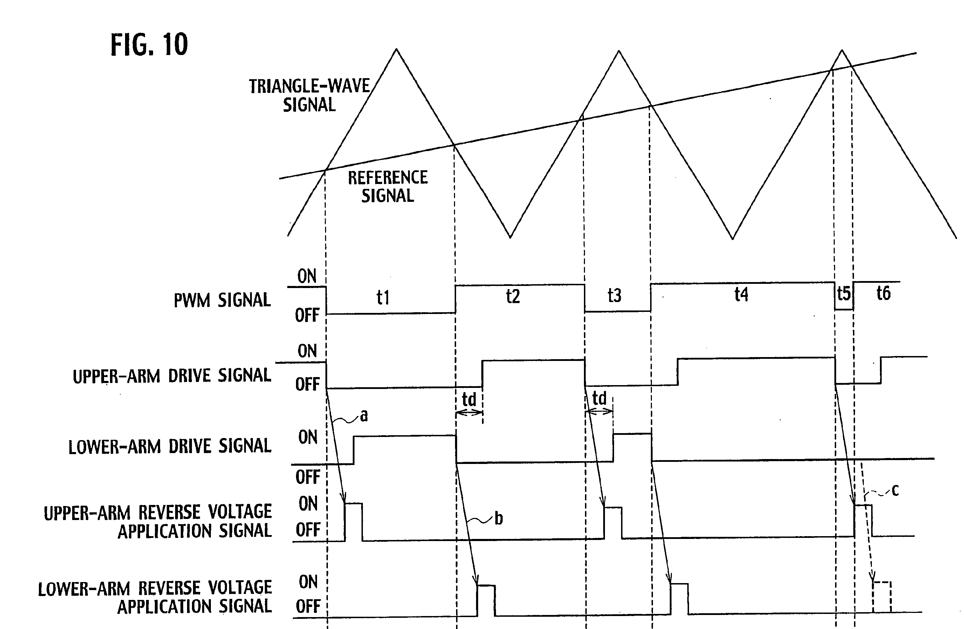

The above case is now explained in detail. FIG.10 is a time chart to show ON and OFF states of a signal generated based on a PWM signal generated from a reference signal and a triangle-wave signal. The PWM signal has reference numbers for each pulse from "t1" to "t6". In the time chart, a pair of main-circuit switching elements is named "upper arm" and "lower arm". "Upper-arm drive signal" and "lower-arm drive signal" are signals to drive MOSFETs, which are switching elements. "Upper-arm reverse voltage application signal" and "lower-arm reverse voltage application signal" are signals to drive switching elements (below called "reverse current prevention switching elements") provided in reverse-current application circuits for applying reverse voltage on parasitic diodes, respectively.

A PWM signal is generated as shown at the top of the time chart in FIG.10. Subject to a condition that the upper-arm drive signal to drive an upper-arm MOSFET changes from ON to OFF as shown in full line "a", reverse voltage is applied on the parasitic diode of the upper-arm MOSFET (the upper-arm reverse voltage application signal becomes ON). Similarly, subject to a condition that the lower-arm drive signal to drive a lower-arm MOSFET changes from ON to OFF as shown in full line "b", reverse voltage is applied on the parasitic diode of the lower-arm MOSFET (the lower-arm reverse voltage application signal becomes ON).

With concurrent application of ON signals on the pair of MOSFETs, provided in the upper and lower arms, a circuit is typically discharged. In order to delay the timing of ON signals to be applied to the upper and lower arms respectively, actual ON signals for the MOSFETs are delayed with a predetermined time from the PWM signal. As shown in a dotted line "c", when a pulse width of the PWM signal becomes shorter than the time width of a dead time "td" (refer to pulse "t5" of the PWM signal), an ON signal to drive the lower arm is not generated. A signal to apply reverse voltage is typically and basically based on timing that a switching element changes from ON, which is delayed, to OFF. As long as the lower-arm drive signal remains OFF, the lower-arm reverse voltage application signal to be output subject to the switching from ON to OFF fails to be generated as shown in a dotted line in the "lower-arm reverse voltage application signal" in FIG.10. Thus, the reverse voltage is not applied on the parasitic diode of the lower-arm MOSFET. It is therefore impossible to regulate the reverse current flowing into the parasitic diode generated at the above timing.

It is noted that the system described in the above Japanese patent application laid-open H10-327585 generates a reverse voltage application signal with use of a signal processed (delayed) from a PWM signal and a drive signal for a switching element with a delay. It is unknown how to generate the processed PWM signal, and therefore it is unclear whether the above situation can be solved or not where a drive signal for a switching element fails to be output.

The present invention is made to solve the above problem. The object of the present invention is to provide a power conversion device capable of reducing power consumption and noise generation, by correcting a switching signal with a switching signal correction unit when a pulse width of a PWM signal is shorter than a dead time in order to prevent the occurrence of the case that a reverse voltage application circuit does not operate in spite of current flowing in the reverse direction through a diode (parasitic diode), and thus regulating a flow of current in the reverse direction through the diode.

A characteristic according to embodiments of the present invention is that a power conversion device comprises: a pair of main circuit switching elements that is connected to a direct-current voltage source in series and supplies power to an inductive load by an ON or OFF control based on a switching signal, wherein at least one of the pair of main circuit switching elements is a FET; diodes that are connected in anti-parallel to the pair of main circuit switching elements, respectively; a PWM signal generation unit that generates a PWM signal for driving the pair of main circuit switching elements; a delay unit that delays ON timing of the switching signal generated based on the PWM signal generated by the PWM signal generation unit with a predetermined delay time; a switching signal correction unit that corrects the switching signal to keep an ON state of a switching element paired with the FET or to have an ON state for the FET for a predetermined time when an ON time of the PWM signal is shorter than the delay time for the FET; and a reverse voltage application circuit that applies reverse voltage which is lower than voltage of the direct-current voltage source on a diode connected in anti-parallel to the FET, based on the switching signal corrected by the switching signal correction unit.

## BRIEF DESCRIPTION OF THE DRAWINGS

FIG.1 is a diagram to show the whole structure of a power conversion device.
FIG.2 is a block diagram to show a configuration of a microcomputer according to the first and second embodiments.
FIG.3 is a flowchart to show a method of determination and waveform diagrams that are output based on respective results of the determination according to the first embodiment.
FIG.4 is a flowchart to show a method of determination and waveform diagrams that are output based on respective results of the determination according to the second embodiment.
FIG.5 is a block diagram to show a configuration of the microcomputer according to the third embodiment.
FIG.6 is a diagram to show the whole structure of a power conversion device according to the third embodiment.
FIG.7 is a flowchart to show a method of determination according to the third embodiment.
FIG.8 is a circuit diagram to show current flow based on a result of the determination according to the third embodiment.
FIG.9 is a circuit diagram to show current flow based on a result of the determination according to the third embodiment.
FIG.10 is a time chart to show signals to be applied to main circuit switching elements and parasitic diodes according to a conventional embodiment.

## BEST MODE FOR CARRYING OUT THE INVENTION

There will be explained embodiments of the present invention in detail with reference to the figures.

(First embodiment)

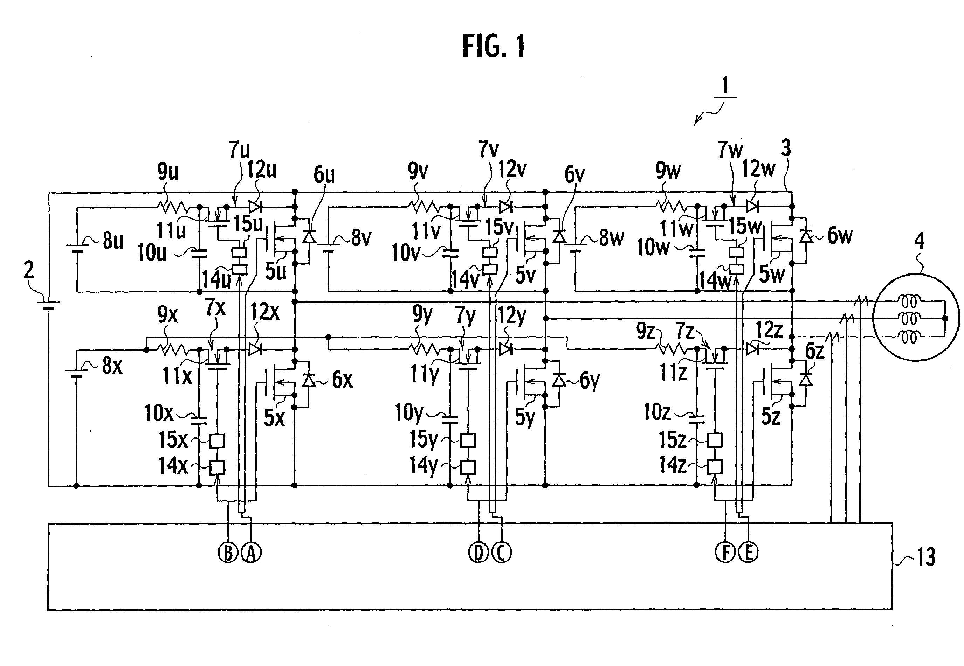

As shown in FIG.1 a power conversion device 1 according to the first embodiment of the present invention has a direct-current voltage source 2, an inverter circuit 3 connected to a power line of the direct-current voltage source 2, and an inductive load 4 such as a motor connected to an output side of the inverter circuit 3.

To the inverter circuit 3 are bridge-connected upper elements MOSFETs 5u,5v,5w and lower elements 5x,5y, 5z, which are main circuit switching elements, in three layers. The MOSFETs "5u and 5x", "5v and 5y", and "5w and 5z" configure a pair of main circuit switching elements, respectively. Between each source and drain of MOSFETs 5u,5v, 5w and 5x,5y,5z are provided diodes 6u,6v,6w and 6x,6y,6z in anti-parallel to the MOSFETs, respectively. It is noted that the use of a MOSFET having a super junction configuration with low on-resistance is preferable from an efficient aspect.

To the diodes 6 are connected reverse voltage application circuits 7u,7v,7w and 7x,7y,7z as reverse voltage application means. These reverse voltage application circuits 7 have low-voltage direct-current voltage sources 8 which have a lower voltage than the direct-current voltage source 2. The reverse voltage application circuits 7x,7y,7z share the low-voltage direct-current voltage source 8x. Between each source and drain of MOSFETs are connected power lines of the low-voltage direct-current voltage sources 8, respectively. Power lines on one side of the reverse voltage application circuits 7 in layers "X", "Y", "Z" are shared with the power lines of the direct-current voltage source 2.

To the low-voltage direct-current voltage sources 8 of the reverse voltage application circuits 7 are connected resistances 9u,9v,9w and 9x,9y,9z in series and further connected condensers 10u,10v,10x and 10x,10y,10z in parallel.

The resistances 9 are provided to prevent in-rush current along with charging of the condensers 10. On the power lines of the low-voltage direct-current voltage sources 8 are connected reverse current prevention switching elements 11u, 11v,11w and 11x,11y,11z, and diodes 12u,12v,12w and 12x,12y,12z to prevent reverse current. The use of a MOSFET having low power consumption is preferable for the reverse current prevention switching elements 11.

The reverse voltage application circuit 7 is driven based on a switching signal output from a microcomputer 13 through a one-shot pulse generation unit 14 (14u,14v,14w and 14x,14y,14z) and a gate drive unit 15 (15u,15v,15w and 15x,15y,15z). The one-shot pulse generation unit 14 and the gate drive unit 15 provide an ON signal to the reverse current prevention switching element 11 with a slight delay from a switching moment of the switching signal from ON to OFF, then keep ON state for a predetermined short time, and provide an OFF signal. Accordingly the reverse current prevention switching element 11 is enabled to apply reverse voltage on a diode of a MOSFET at a term around the ON state of other MOSFET paired with the MOSFET. Thus, it is possible to regulate the reverse current that flows into the (parasitic) diode connected in anti-parallel to the MOSFET.

The microcomputer 13 is connected to the inverter circuit 3 through outputs "A,C,E" and "B,D,F". The output "A"("C,E") transfers a corrected switching signal output by a below-described switching signal correction unit 13e to both of the main circuit switching element 5 in the layer "U"("V,W") and the reverse voltage application circuit 7 through the one-shot pulse generation unit 14 and the gate drive unit 15 in the layer "U"("V,W"). Similarly, the output "B"("D,F") transfers a corrected switching signal output by the switching signal correction unit 13e to both of the main circuit switching element 5 in the layer "X"("Y,Z") and the reverse voltage application circuit 7 through the one-shot pulse generation unit 14 and the gate drive unit 15 in the layer "X"("Y,Z").

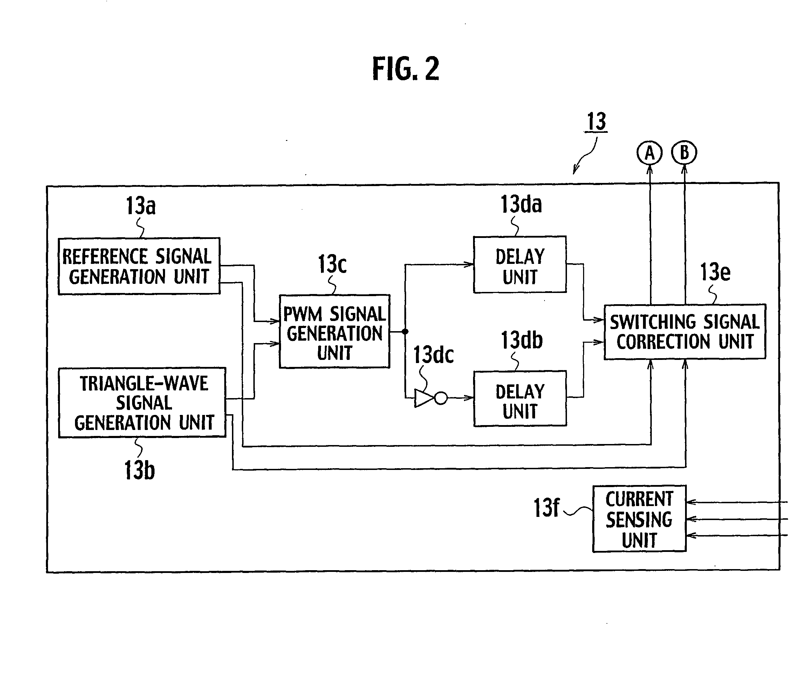

As shown in FIG.2 the microcomputer 13 comprises: a reference signal generation unit 13a to generate a reference signal; a triangle-wave generation unit 13b to generate a triangle-wave; a PWM signal generation unit 13c to generate a PWM signal for driving a pair of main circuit switching elements; an inverter 13dc to invert the PWM signal as a PWM signal for a lower switching element; delay units 13da, 13db to delay ON timings of PWM signals with the predetermined time (dead time), respectively; a switching signal correction unit 13e to compare a pulse width of a PWM signal and the dead time and when the pulse width of one of PWM signals is shorter than the dead time, keep ON state of other switching element of a pair of main circuit switching elements; and a current sensing unit 13f. The current sensing unit 13f measures a value of current or the direction of current between the inverter circuit 3 and the inductive load 4 in each layer in order to control the speed of the motor which is the inductive load.

The reference signal generation unit 13a and the triangle-wave generation unit 13b respectively generate a reference signal and a triangle-wave signal that serve as a basis for a PWM signal. The reference signal generation unit 13a and triangle-wave generation unit 13b are provided in the microcomputer 13 according to the present embodiment. They may be provided outside of the microcomputer 13.

The PWM signal generation unit 13c generates a PWM signal from the reference signal and the triangle signal. The PWM signal serves as a basis of switching signals for applying voltage on the switching elements. As shown in FIG. 10 a PWM signal is generated to be ON and OFF based on the result of a comparison between a reference signal and a triangle signal.

The delay units 13d delay ON signals for the upper and lower switching elements with the predetermined time (dead time) in order to prevent short circuit due to concurrent ON signals on the upper and lower switching elements. OFF signals are not delayed. It is noted that from an efficient aspect the predetermined time (dead time) is preferable to be as short as possible while preventing the short circuit.

PWM signals delayed for the switching elements by the delay units 13d are input to the switching signal correction unit 13e. A reference signal generated by the reference signal generation unit 13a and a triangle-wave signal generated by the triangle-wave generation unit 13b are also input to the switching signal correction unit 13e.

The switching signal correction unit 13e compares the dead time to be added to a PWM signal and a pulse width of a PWM signal generated from the reference signal and the triangle wave-signal in advance. When the pulse width of one of PWM signals is shorter than the dead time, the switching signal correction unit 13e corrects and outputs a PWM signal to keep ON state of other switching element of a pair of main circuit switching elements. The corrected PWM signal is applied to the pair of main circuit switching elements as a corrected switching signal.

It is noted that only layers "U" and "X" as a pair of main circuit will be explained below as an example, for simplification. In practice the three main circuits of the layers "U,V,W" and "X,Y,Z" are provided with the delay unit and the switching signal correction unit 13e, respectively. Thus there are performed six outputs through the outputs "A" to "F" corresponding to each switching element.

A corrected switching signal for the upper switching element output by the switching signal correction unit 13e is input to both of the main circuit switching element 5u(5v,5w) of the layer "U"(V,W) and the one-shot pulse generation unit 14u(14v,14w) of the layer "U"(V,W) through the output "A"(C,E). Based on the corrected switching signal, the reverse current prevention switching element 11 provided in the reverse voltage application circuit 7 is turned ON at a predetermined timing and for a predetermined time.

Similarly, a corrected switching signal for the lower switching element output by the switching signal correction unit 13e is input to both of the main circuit switching element- 5x(5y,5z) and the one-shot pulse generation unit 14x(14y, 14z) of the layer "X"(Y,Z) through the output "B"(D,F). Based on the corrected switching signal, the reverse current prevention switching element 11 provided in the reverse voltage application circuit 7 is turned ON at a predetermined timing and for a predetermined time.

The one-shot pulse generation unit 14 generates a waveform for outputting a reverse voltage application signal and a signal generated thereby is input to the reverse current prevention switching element 11 through the gate drive unit 15. This enables to apply reverse voltage on the diode 6 provided in anti-parallel to the MOSFET through the reverse current prevention switching element 11 and thus regulate reverse current flowing into the diode 6.

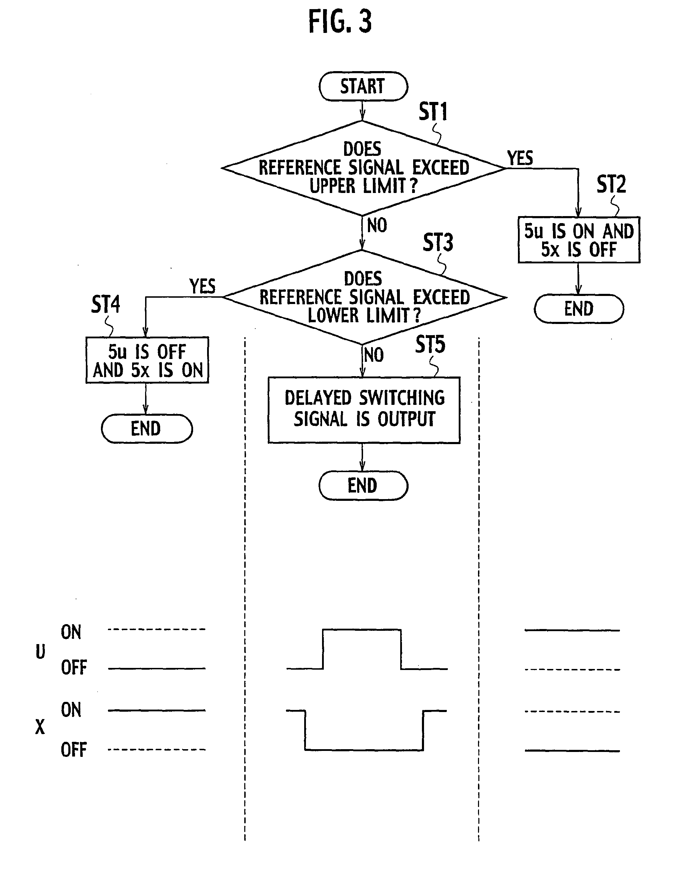

In the first embodiment a comparison and determination way of the pulse width of a PWM signal and the dead time by the switching signal correction unit 13e is performed as follows. FIG.3 shows a flowchart and wave forms showing conduction states of main circuit switching elements in each case. Firstly it is determined whether a reference signal exceeds an upper limit provided based on a triangle-wave signal (ST1). The upper limit "$V_A$" is obtained as follows:

$$V_A = V_{tri} \times \frac{t_{pwm} - 2td}{t_{pwm}}. \qquad \cdots(1)$$

Here "$V_{tri}$" is the triangle-wave signal, "$t_{pwm}$" one cycle of the triangle-wave, and "td" a dead time. It is noted that there will be explained a pair of main circuit switching elements 5u,5x of layers "U","X" as an example among the pairs of main circuit switching elements 5 provided on the power conversion device 1. Operations of other pairs of main circuit switching elements of the layers "V,Y" and "W,Z" are same as those of the layers "U,X".

When the reference signal exceeds the upper limit "$V_A$" (YES in ST1), a pulse width of a PWM signal becomes shorter than the dead time to be added to prevent the short circuit of the layers "U,X".

For example, when the main circuit switching element 5u of the layer "U" is ON while current from the inductive load 4 flows thereto and then the main circuit switching element 5u is turned OFF, current flowing through the inductive load 4 flows into the diode 6x connected in anti-parallel to the main circuit switching element 5x of the layer "X". At this time, as a driving signal to drive the main circuit switching element 5x has a shorter ON time than the dead time, the drive signal to drive the main circuit switching element 5x is not generated. Accordingly a reverse voltage application signal is not generated, which is subject to OFF state of the drive signal for the main circuit switching element 5x, and no reverse voltage is applied to the diode 6x of the main circuit switching element 5x. Thus, when the main circuit switching element 5u of the layer "U" is turned ON again, a part of the current flowing from the layer "U" through the inductive load 4 flows into the diode 6x as a large reverse current.

In this case it is due to the OFF state of the main circuit switching element 5u of the layer "U" corresponding to the layer "X" that the reverse current flows into the diode 6x of the main circuit switching element 5x. Therefore, when the reference signal exceeds the upper limit "$V_A$", a drive signal to keep the ON state is output to the main circuit switching element 5u. With such determination by the switching signal correction unit 13e, the drive signal without OFF state is applied on the main circuit switching element 5u (ST2). Accordingly no reverse current flows through the diode 6x of the main circuit switching element 5x. It is noted that a drive signal to drive the main circuit switching element 5x of the layer "X" is obviously kept in OFF state by inverting a switching signal for the layer "U". This is kept until the next timing of determination.

Under ST2 in FIG.3, there are shown signals to be applied to the main circuit switching elements 5u and 5x, respectively. The upper column shows ON state wherein a switching signal is applied and the lower column shows OFF state wherein no switching signal is applied. In this case the switching element 5u is kept in ON state by a drive signal, while the switching element 5x is kept in OFF state with no generation of a drive signal.

When the reference signal does not exceed the upper limit (NO in ST1), it is determined whether the reference signal exceeds a lower limit "$V_B$" (under the lower limit) provided based on the triangle signal (ST3). The lower limit "$V_B$" is obtained as follows:

$$V_B = V_{tri} \times \frac{2td}{t_{pwm}}. \qquad \cdots(2)$$

When the reference signal exceeds the lower limit "$V_B$" (YES in ST3), the pulse width of the PWM signal becomes shorter than the dead time to be added to prevent the short circuit of the layers "U,X". It is noted that unlike the above upper limit "$V_A$", a drive signal to drive the main circuit switching element 5u is not generated.

In this case it is due to the OFF state of the main circuit switching element 5x that the reverse current flows into the diode 6u of the main circuit switching element 5u. Therefore, when the reference signal exceeds the upper limit $V_B$, a drive signal to keep ON state is output to the main circuit switching element 5x. With such determination by the switching signal correction unit 13e the drive signal without OFF state is applied on the main circuit switching element 5x (ST4). It is noted that the drive signal to drive the main circuit switching element 5u is kept in OFF state. This is kept until the next timing of determination.

As shown in switching signals under ST4 in FIG.3, the switching element 5 is kept in ON state by a drive signal, while the switching element 5u is kept in OFF state.

When the reference signal remains between the upper limit "$V_A$" and the lower limit "$V_B$" (YES in ST3), the switching signal correction unit 13e outputs switching signals without correction, which are PWM signals based on the comparison result between the reference signal and the triangle signal-and delayed by the delay unit 13d (ST5). As shown in wave forms in the lower part of FIG.3, drive signals to turn ON or OFF are provided to the main circuit switching elements 5u,5x of the layers "U,X". Then a reverse voltage application signal is generated based on the drive signals. Based on the reverse voltage application signal, reverse voltage is applied to the diode.

As the above, when an ON signal for one of the main circuit switching elements is not to be generated due to a short pulse width of the PWM signal, the switching signal correction unit corrects a switching signal and outputs it to other paired main circuit switching element to keep its ON state. Accordingly it is possible to meet a drive signal for a main circuit switching element to the timing that reverse current is to flow into a diode. Thus it is possible to certainly regulate reverse current flowing into the diode (parasitic diode). Moreover, with only a switching signal output by the microcomputer, it is possible to apply reverse voltage at an appropriate timing on the diode connected in anti-parallel to the FET.

(Second embodiment)

There will be explained the second embodiment according to the present invention. It is noted that identical elements with those explained in the above first embodiment are given same reference numbers, and a detailed explanation for the identical elements is omitted.

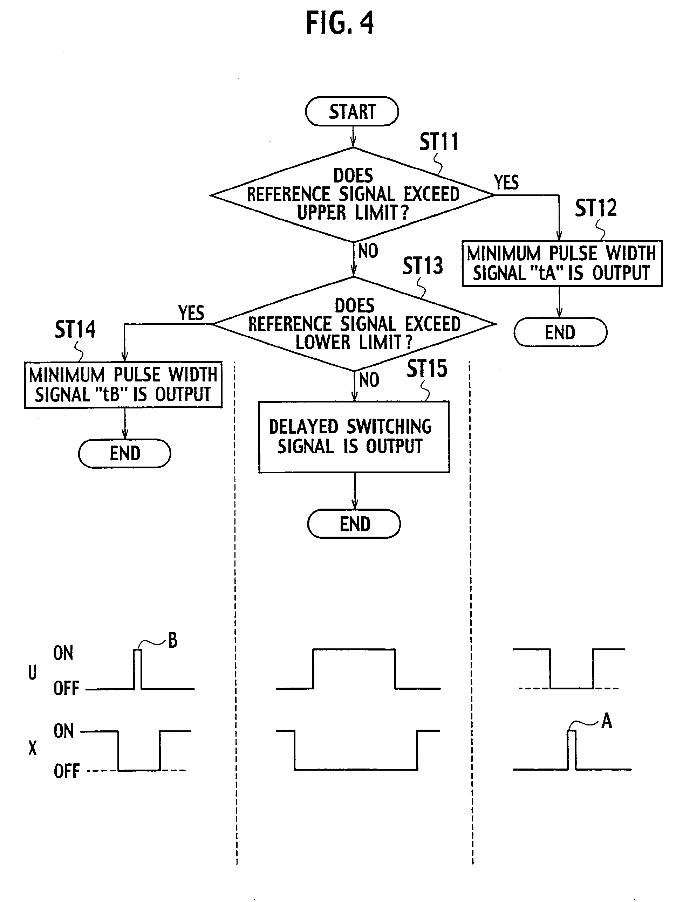

As shown in FIG.4 the second embodiment differs from the first embodiment in a correction method of a switching signal by the switching signal correction unit 13e. In the first embodiment a signal is corrected and output to uninterruptedly keep the ON state of either one of the pair of main circuit switching elements in exceed of reference values. In the second embodiment a signal with a predetermined width is output in exceed of reference values.

As described above the switching signal correction unit 13e determines whether a reference signal exceeds an upper limit (ST11). It is noted that the upper limit of the second embodiment differs from that of the first embodiment. The upper limit "$V_C$" is represented as follows:

$$V_C = V_{tri} \times \frac{t_{pwm} - 2td - A}{t_{pwm}}. \qquad \cdots (3)$$

Here "$V_{tri}$" represents a triangle-wave signal, "$t_{pwm}$" one cycle of the triangle-wave signal, and "td" a dead time. "A" is a duty ratio provided in order to output a signal with a predetermined width. When the reference signal exceeds the upper limit $V_A$ (YES in ST11), a pulse width of a PWM signal becomes shorter than the dead time to be added to prevent the short circuit of the layers "U,X".

In this case no reverse voltage application signal is generated, which is subject to OFF state of a drive signal for the main circuit switching element 5x. Thus no reverse voltage is applied to the diode 6x of the main circuit switching element 5x.

In such a case, in order to generate a drive signal to certainly turn ON or OFF the main circuit switching element 5x, the switching signal correction unit 13e ignores switching signals output by the delay units 13da,db. Then the switching signal correction unit 13e outputs a switching signal with the predetermined minimum pulse width "tA" (ST12). It is noted that if the minimum pulse width "tA" is set too long, waveform output from the main circuit loses the shape of a sine wave. Thus it is preferable to set the pulse width as short as possible.

As a result, both of the pair of main circuit switching elements are certainly turned ON or OFF. With a corrected switching signal the generation of a reverse voltage application signal is enabled. This determination is executed for every cycle of the triangle-wave.

Under ST12 in FIG.4 there are shown signals to be applied to the main circuit switching elements 5u,5x. In this case a switching signal with the minimum pulse width "tA" is provided to the switching element 5x, while a switching signal of an inverted signal of the minimum pulse width "tA" with a delay time added is provided to the switching element 5u by the switching signal correction unit 13e.

When the reference signal does not exceed the upper limit (NO in ST11), it is determined whether the reference signal exceeds a lower limit provided based on the triangle-wave signal (ST13). The lower limit "$V_D$" is obtained as follows:

$$V_D = V_{tri} \times \frac{2td + B}{t_{pwm}}. \qquad \cdots (4)$$

When the reference signal exceeds the lower limit "$V_D$" (YES in ST13), the pulse width of the PWM signal becomes shorter than the dead time to be added to prevent the short circuit of the layers "U,X". It is noted that unlike the above upper limit "$V_C$" the switching signal correction unit 13e generates a switching signal with the minimum pulse width "tB" not for the layer "X" but for the layer "U" (ST14).

Under ST14 in FIG.4 there are shown switching signals to be applied to the main circuit switching elements 5u,5z. In this case a switching signal with the minimum pulse width "tB" is provided by the switching signal correction unit 13e to the switching element 5u, while a signal of an inverted signal of the minimum pulse width "tB" with a delay time added is provided to the switching element 5x by the switching signal correction unit 13e. It is noted that when the reference signal remains between the upper limit "$V_C$" and the lower limit "$V_D$" (YES in ST13), the switching signal correction unit 13e outputs switching signals output by the delay unit 13d without correction (ST15).

As described above it is possible to reduce power consumption and noise generation by certainly generating and outputting a switching signal having ON state of at least a predetermined minimum pulse width by the switching signal correction unit in order to prevent that the reverse voltage application circuit does not operate in spite of current flowing in the reverse direction on the diode (parasitic diode), and thus regulating the current flow in the reverse direction on the diode.

(Third embodiment)

There will be explained the third embodiment according to the present invention. It is noted that identical elements with those explained in the above first and second embodiments are given with same reference numbers and a detailed explanation is omitted.

The third embodiment is characterized in that the operation of the reverse current prevention element 11 is controlled based on the direction of current flowing between the inverter circuit 3 and the inductive load 4.

There flows reverse current to the diode 6 only when one of main circuit switching elements 5 is turned ON during current flowing in forward direction through the diode connected in anti-parallel to other paired main circuit switching element 5. Accordingly the number of drives of the reverse current prevention switching element 11 can be reduced by detecting or predicting the direction of current and then determining whether the operation of the reverse current prevention switching element 11 is necessary or not. Thus power consumption of this circuit is reduced.

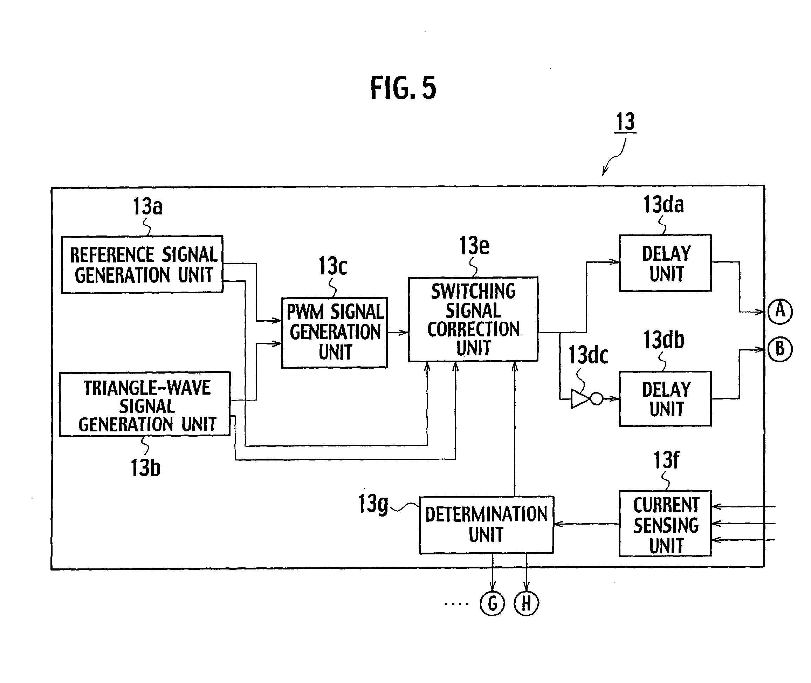

As shown in FIG.5 the microcomputer of the third embodiment has a determination unit 13g connected to the current measurement unit 13f. The determination unit 13g determines which reverse current prevention switching element 11 to control, based on the direction of current or a value of current measured by the current measurement unit 13f. When the determination unit 13g determines not to control the reverse current prevention switching element 11, it also prohibits a correction by the switching signal correction unit 13e, as the correction of the switching signal is unnecessary.

The determination unit 13g determines a possibility that reverse voltage will flow into the diode 6 connected in anti-parallel to the main circuit switching element 5 due to the application of the next switching signal. The determination is based on outputs measured by the current measurement unit 13f, prior to generation of the next switching signal. When there is the possibility that reverse current flows, the determination unit 13g provides a command to a corresponding one-shot pulse generation unit 14 to permit the operation of the reverse current prevention switching element 11 corresponding to the diode 6. When there is no possibility, the determination unit 13g provides a command to the corresponding one-shot pulse generation unit 14 to prohibit the operation of the reverse current prevention switching element 11. In such a case the determination unit 13g simultaneously provides a signal to the switching signal correction unit 13e to prohibit the correction, as the correction of the corresponding switching signal is also unnecessary.

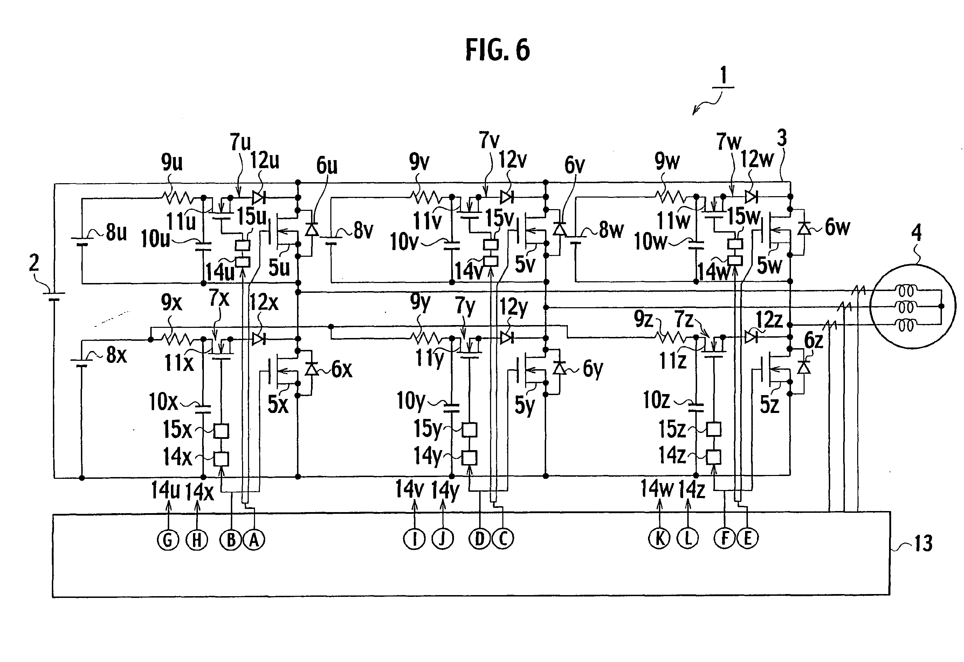

Through an output "G"(H,I,J,L) shown in FIG.6, which connects the microcomputer 13 and the one-shot pulse generation units 14, a command to permit or prohibit the operation is output from the determination unit 13g to the one-shot pulse generation unit 14. More precisely a command to permit or prohibit the operation of the one-pulse generation unit 14 is input. At the same time a command to permit or prohibit the control operation is output by the determination unit 13g to the switching signal correction unit 13e.

As shown in FIG.5 the switching signal correction unit 13e is provided between the PWM signal generation unit 13c and the delay units 13da,13db, and performs a correction on a PWM signal that is generated by the PWM signal generation unit 13c and not delayed yet. With this configuration there is no need to correct two switching signals to be applied to the upper and lower elements, and only a need to correct a single PWM signal. Thus the configuration can be considerably simplified.

It is noted that when the switching signal correction unit 13e in this configuration is made to output a signal with the minimum pulse width as described in the second embodiment, there is a need to add a delay time to the minimum pulse width "tA","tB" of the second embodiment, respectively.

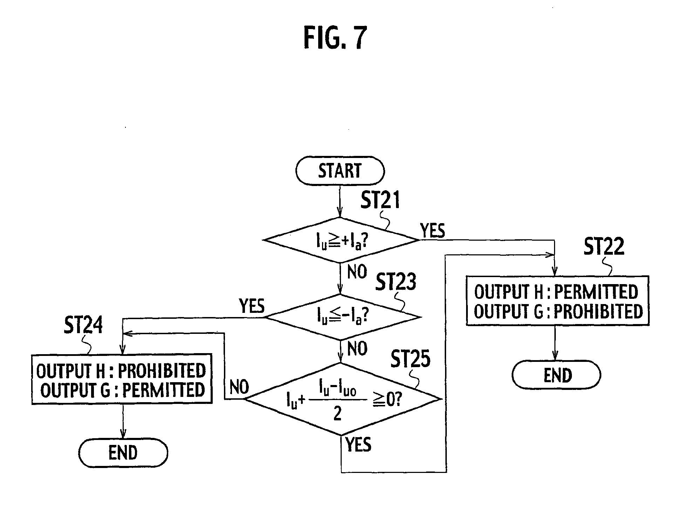

As shown in a flowchart in FIG.7 it is determined whether current "$I_U$" presently flowing between the inverter circuit 3 and the inductive load 4 is equal to or more than "$+I_a$" or not (ST21). When it is equal to or more than "$+I_a$" (YES in ST21), it is determined that current flows from the inverter circuit 3 to the inductive load 4 and the process is proceeded to ST22. "$+I_a$" shows that current flows from the inverter circuit 3 to the inductive load 4. It is noted that the direction of current is a direction decided for convenience in the third embodiment. The decision may be anything as long as the determination of the current direction is possible.

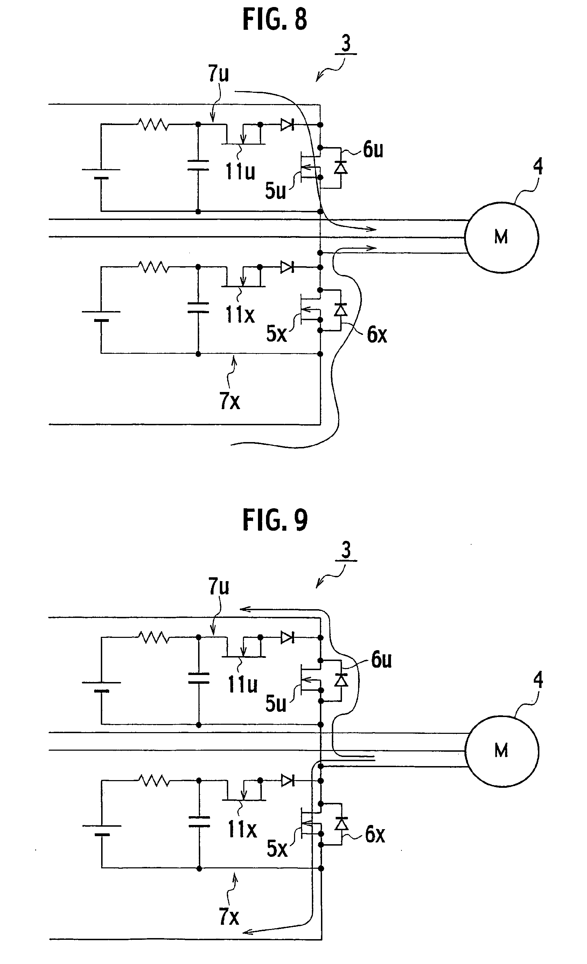

In this case as shown in FIG.8 current flows to the inductive load 4 through the main circuit switching element 5u in the layer "U" and through the diode 6x in the layer "X". Thus there is a need to provide a drive signal to the reverse current prevention switching element 11x in the layer "X" at an appropriate timing and to control the application of reverse voltage on the diode 6x to regulate current in reverse direction. Then the determination unit 13g provides a signal to the one-shot pulse generation unit 14x through the output "H" to permit the operation to apply reverse voltage (ST22). As there is no current flowing into the diode 6u in the layer "U", the determination unit 13g provides a signal to the one-shot pulse generation unit 14u through the output "G" to prohibit the operation (ST22). Thus the reverse current prevention switching element 11u does not operate.

When the current "$I_U$" presently flowing between the inverter circuit 3 and the inductive load 4 is not equal to or more than "$+I_a$", it is then determined whether the current "$I_U$" presently flowing between the inverter circuit 3 and the inductive load 4 is equal to or less than "$-I_a$" or not (ST23). "$-I_a$" shows that current flows from the inductive load 4 to the inverter circuit 3. When it is equal to or less than "$-I_a$" (YES in ST23), it is determined that current flows from the inductive load 4 to the inverter circuit 3 as shown in FIG.9. The determination unit 13g provides a permission signal through the output "G" to perform the operation to apply reverse voltage by the reverse current prevention switching element 11u (ST24). At the same time the determination unit 13g provides a signal to the one-shot pulse generation unit 14x through the output "H" to prohibit the operation (ST24).

When the current "$I_U$" is not equal to or less than "$-I_a$", it is possible to perform a more detailed determination as follows (ST25):

$$I_U + \frac{I_U - I_{U0}}{2} \geq 0. \qquad \cdots (5)$$

Here "$I_U$" represents a latest measured current value, and "$I_{U0}$" a previous measured current value. The second item on the left side indicates a predicted current value. Dividing by two is due to that a signal has its waveform changed mostly at the center of one cycle of a PWM signal, and the prediction of a current value at this point, that is, around the half of the one cycle is most reliable.

When the left side is larger than the right side, the direction of current is "+", that is, current flows from the inverter circuit 3 to the inductive load 4 as shown in FIG.8 (YES in ST25). The reverse current prevention switching element 11x is permitted to output a reverse voltage application signal, and current in reverse direction on the diode 6x is regulated by the reverse voltage (ST22). At the same time as no current flows into the diode 6u, the operation of the reverse voltage application circuit 7u to apply reverse voltage is prohibited(ST22).

When the right side is larger than the left side, the direction of current is "-". That is, current flows from the inductive load 4 into the inverter circuit 3 as shown in FIG.9 (ST25). The operation of the reverse current prevention switching element 11u is permitted, and the operation of the reverse current prevention switching element 11x is prohibited (ST24).

As described above, with use of current measurement unit 13f originally provided for controlling the inductive load 4, the reverse current prevention switching element 11 is operated only as necessary. Thus there is no increasing of power loss by unnecessarily turning on the reverse current prevention switching element 11 with no possibility of reverse current.

It is noted that unlike the third embodiment it is possible to include the functions of the one-shot pulse generation unit 14 and the gate drive unit 15 in the microcomputer and directly drive the reverse current prevention switching element 11 from an output terminal of the microcomputer.

Each embodiment is explained with employment of two MOSFETs for the pair of main circuit switching elements 5. It is also possible to employ only one MOSFET for either one of the main circuit switching elements 5 and an IGBT (Insulated Gate Bipolar Transistor) or a transistor for the other main circuit switching element. In this case only when reverse voltage flows to the parasitic diode of the MOSFET, switching signals may be corrected by the switching signal correction unit. Moreover the embodiments of the present invention employ three-layer inverters for driving a motor for example. It is not limited to the motor, and any inductive load may be applied. A single-layer inverter is also applicable. The embodiments according to the present invention are explained as the above. The invention is not however limited to the above embodiments and can be concreted in practical steps by modifying elements within the range not deviating from the gist. By combining the elements disclosed in the above embodiments a various types of the invention can be formed. For example it is possible to delete some elements from all elements shown in the embodiments. Moreover elements according to different embodiments may be combined appropriately.

**INDUSTRIAL APPLICABILITY**

The present invention is, for example, used for a various power conversion devices such as an inverter device or a converter device.

**Claims**

1.   A power conversion device comprising:

a pair of main circuit switching elements that is connected to a direct-current voltage source in series and supplies power to an inductive load by an ON or OFF control based on a switching signal, wherein at least one of the pair of main circuit switching elements is a FET;
diodes that are connected in anti-parallel to the pair of main circuit switching elements, respectively;
a PWM signal generation unit that generates a PWM signal for driving the pair of main circuit switching elements;
a delay unit that delays ON timing of the switching signal generated based on the PWM signal generated by the PWM signal generation unit with a predetermined delay time;
a switching signal correction unit that corrects the switching signal to keep an ON state of a switching element paired with the FET when an ON time of the PWM signal is shorter than the delay time for the FET; and
a reverse voltage application circuit that applies reverse voltage which is lower than voltage of the direct-current voltage source on a diode connected in anti-parallel to the FET, based on the switching signal corrected by the switching signal correction unit.

2.   A power conversion device comprising:

a pair of main circuit switching elements that is connected to a direct-current voltage source in series and-supplies power to an inductive load by an ON or OFF control based on a switching signal, wherein at least one of the pair of main circuit switching elements is a FET;
diodes that are connected in anti-parallel to the pair of main circuit switching elements, respectively;
a PWM signal generation unit that generates a PWM signal for driving the pair of main circuit switching elements;
a delay unit that delays ON timing of the switching signal generated based on the PWM signal generated by the PWM signal generation unit with a predetermined delay time;
a switching signal correction unit that corrects the switching signal to have an ON state for the FET for a predetermined time when an ON time of the PWM signal is shorter than the delay time for the FET; and
a reverse voltage application circuit that applies reverse voltage which is lower than voltage of the direct-current voltage source on the diode connected in anti-parallel to the FET, based on the switching signal corrected by the switching signal correction unit.

3.   The power conversion device of claim 1 or 2 further comprising:

a determination unit that determines the direction of current flowing between the pair of main circuit switching elements and the inductive load,

wherein a correction by the switching signal correction unit and an application of the reverse voltage on the diode by the reverse voltage application unit are based on a result of a determination by the determination unit.

# FIG. 1

EP 1 933 450 A1

# FIG. 2

EP 1 933 450 A1

# FIG. 3

START

ST1

DOES REFERENCE SIGNAL EXCEED UPPER LIMIT?

YES

ST2

5u IS ON AND 5x IS OFF

END

NO

ST3

DOES REFERENCE SIGNAL EXCEED LOWER LIMIT?

YES

ST4

5u IS OFF AND 5x IS ON

END

NO

ST5

DELAYED SWITCHING SIGNAL IS OUTPUT

END

U
ON
OFF

X
ON
OFF

# FIG. 4

START

ST11
DOES REFERENCE SIGNAL EXCEED UPPER LIMIT? — YES

ST12
MINIMUM PULSE WIDTH SIGNAL "tA" IS OUTPUT

END

NO

ST13
DOES REFERENCE SIGNAL EXCEED LOWER LIMIT?

YES

ST14
MINIMUM PULSE WIDTH SIGNAL "tB" IS OUTPUT

END

NO

ST15
DELAYED SWITCHING SIGNAL IS OUTPUT

END

U
ON
OFF
B

X
ON
OFF

A

# FIG. 5

# FIG. 6

EP 1 933 450 A1

# FIG. 7

# FIG. 8

# FIG. 9

# FIG. 10

**INTERNATIONAL SEARCH REPORT**

| International application No. |
| --- |
| PCT/JP2006/317649 |

A.  CLASSIFICATION OF SUBJECT MATTER
*H02M7/48(2007.01)i, H02M1/08(2006.01)i*

According to International Patent Classification (IPC) or to both national classification and IPC

B.  FIELDS SEARCHED

Minimum documentation searched (classification system followed by classification symbols)
H02M7/48, H02M1/08

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| Y<br>A | JP 10-327585 A  (Toshiba Corp.),<br>08 December, 1998 (08.12.98),<br>Full text; all drawings<br>& US 6058037 A         & EP 0880221 A2 | 2,3<br>1 |
| Y<br>A | JP 5-49263 A  (Matsushita Electric Industrial<br>Co., Ltd.),<br>26 February, 1993 (26.02.93),<br>Full text; all drawings<br>(Family: none) | 2,3<br>1 |

☐  Further documents are listed in the continuation of Box C.          ☐  See patent family annex.

| | |
| --- | --- |
| *    Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>    20 November, 2006 (20.11.06) | Date of mailing of the international search report<br>    28 November, 2006 (28.11.06) |
| --- | --- |
| Name and mailing address of the ISA/<br>    Japanese Patent Office | Authorized officer |
| Facsimile No. | Telephone No. |

Form PCT/ISA/210 (second sheet) (April 2005)

**REFERENCES CITED IN THE DESCRIPTION**

**Patent documents cited in the description**

• JP H10327585 B